# EUROPÄISCHE PATENTSCHRIFT

(11) **EP 2 625 304 B1**
(45) Veröffentlichungstag und Bekanntmachung des Hinweises auf die Patenterteilung: **09.01.2019**
(21) Anmeldenummer: 11813769.4
(22) Anmeldetag: 04.10.2011
(51) Int. Cl.: C23C 14/04, C23C 30/00, C23C 28/04, C23C 28/00, B23B 27/14

(54) **WENDESCHNEIDPLATTE UND VERFAHREN ZU DEREN HERSTELLUNG**
INDEXABLE INSERT, AND METHOD FOR THE PRODUCTION THEREOF
PLAQUETTE DE COUPE AMOVIBLE ET SON PROCÉDÉ DE PRODUCTION

(30) Priorität: 08.10.2010 DE 102010038077
(43) Veröffentlichungstag der Anmeldung: 14.08.2013
(73) Patentinhaber: MSM Krystall GBR, 12165 Berlin (DE)
(72) Erfinder: MECKLENBURG, Arno, 10999 Berlin (DE)
(74) Vertreter: Gossel, Hans K.
(86) Internationale Anmeldenummer: PCT/DE2011/050038
(87) Internationale Veröffentlichungsnummer: WO 2012/048692

(56) Entgegenhaltungen:
- JP-A- 8 039 132
- US-A- 5 700 551
- IRIE M ET AL: "Deposition of Ni-TiN nano-composite films by cathodic arc ion-plating", NUCLEAR INSTRUMENTS & METHODS IN PHYSICS RESEARCH, SECTION - B:BEAM INTERACTIONS WITH MATERIALS AND ATOMS, ELSEVIER, AMSTERDAM, NL, Bd. 121, Nr. 1, 1. Januar 1997 (1997-01-01), Seiten 133-136, XP004057891, ISSN: 0168-583X, DOI: 10.1016/S0168-583X(96)00543-5
- Uwe Böhme: "Hartstoffe", Institut für Anorganische Chemie der Technischen Universität Bergakademie Freiberg , 10 November 2009 (2009-11-10), Retrieved from the Internet: URL:http://www.chem.tu-freiberg.de/~boehme /materialien/hartstoffe/hartstoffe.html [retrieved on 2015-11-09]

## Beschreibung

### Technisches Gebiet

Die Erfindung betrifft ein Verfahren zur Herstellung von Wendeschneidplatten durch Physikalische Gasphasenabscheidung (engl.: physical vapour deposition, kurz: PVD).

### Hintergrund

Für die Hartbearbeitung (spanabhebende Bearbeitung von gehärteten Werkstoffen mit einer Härte von z.B. 54 bis 62 HRC) sind Wendeschneidplatten allgemein bekannt, deren Schneiden aus polykristallinem Diamant (PKD) oder (zumeist keramisch gebundenem) kubisch kristallinem Bornitrid (CBN) bestehen. Zur Herstellung der Wendeschneidplatten werden Scheidplättchen aus PKD oder CBN hergestellt und, beispielsweise durch Vakuumlöten, auf einem Grundkörper befestigt. In der Publikation M. Irie et al., "Deposition of Ni-TiN nano-composite films by cathodic arcion-plating", in Nuclear Instruments and Methods in Physics Research, Section B, Bd. 121 (1997), S. 133-136, ist auch das Abscheiden von einem Nanokomposit aus Nickel (Ni) und Titannitrid (TiN) auf einem Schneidplättchen-Grundkörper beschrieben. In der Publikation JP H08-39132 ist beschrieben, auf einem Grundkörper aus Hartmetall eine Kohlenstoffbeschichtung abzuscheiden. In der Publikation "Hartstoffe" von Uwe Böhme des Instituts für Anorganische Chemie der Technischen Universität Bergakademie Freiberg vom 10. November 2009 sind Hartstoffe sowie deren Unterteilung beschrieben. US 5 700 551 A beschreibt einen Lagenaufbau zum Beschichten von Werkzeugoberflächen. Üblich sind Grundkörper aus Hartmetall. PKD und CBN gehören zu den härtesten bekannten Stoffen. Sie zeichnen sich neben der hohen Härte durch sehr hohe Wärmeleitfähigkeiten bei gleichsam geringen thermischen Ausdehnungskoeffizienten aus. Dem gegenüber stehen jedoch verschiedene Nachteile, welche den Einsatzbereich von PKD- bzw. CBN-Schneidplatten stark einschränken. Zu nennen ist beispielsweise die große Sprödigkeit dieser Stoffe, wegen derer sie nur zum kontinuierlichen Schneiden eingesetzt werden können. PKD ist zwar härter als CBN, aber wegen der großen Löslichkeit von Kohlenstoff in Eisen zur spanabhebenden Bearbeitung von eisenbasierten Werkstoffen nur schlecht oder gar nicht tauglich, wegen des bereits bei moderaten Temperaturen großen Diffusionsverschleißes. Schneiden (Schneidplättchen) aus PKD oder CBN sind zudem sehr teuer, was an der aufwändigen Herstellung der (bei Normalbedingungen thermodynamisch instabilen) Werkstoffe liegt. Üblich ist die Herstellung feiner Diamant- bzw. CBN-Pulver unter sehr hohen Drücken und bei hohen Temperaturen (sogenannte "high pressure high temperature"-Verfahren, kurz HPHT-Verfahren), welche durch Quenchen hergestellt und anschließend gesiebt werden. Die feinen Pulver werden sodann nach verschiedenen Verfahren gesintert.

Des Weiteren ist für die Herstellung von Diamant-Scheidplättchen die Herstellung durch Abscheiden einer Dickschicht mittels Chemischer Gasphasenabscheidung (chemical vapour deposition, kurz: CVD) bekannt. Die so erhaltenen Plättchen sind verfahrensbedingt von sehr homogenem Gefüge und können in feiner Körnung hergestellt werden. Allerdings sind die Abscheideraten gering, wodurch sich hohe Prozessdauern ergeben. Des Weiteren ist das Trennen bzw. Vereinzeln der der so erhaltenen Platten in einzelne Schneidplättchen verhältnismäßig aufwendig.

Neben Schneidplatten aus PKD oder CBN sind Schneidplatten aus Hartmetall gebräuchlich. Diese werden üblicherweise auf pulvermetallurgischem Wege bzw. durch Sintern hergestellt, wobei z.B. WC/Co (Wolframcarbid-Kobalt, allg. "Hartmetall") ein wichtiger Basiswerkstoff ist. Häufig werden Wendeschneidplatten mittels PVD oder CVD mit harten, abriebfesten, korrosionsbeständigen und ggf. auch reibungsmindernden Beschichtungen (sogenannte tribologische Schichten) versehen, um ihren Verschleiß zu mindern und/oder höhere Zerspanungsgeschwindigkeiten und bessere Schnittqualitäten zu ermöglichen. Zu den Verfahren der PVD gehören unter anderem thermisches Verdampfen, Elektronenstrahlverdampfen, (engl. electron beam evaporation), Laserstrahlverdampfen (engl. pulsed laser deposition, pulsed laser ablation), Lichtbogenverdampfen (engl. arc evaporation, häufig: Arc-PVD), Molekularstrahlepitaxie (engl. molecular beam epitaxy), Sputtern, Ionenstrahlgestützte Deposition (engl. ion beam assisted deposition, IBAD) und Ionenplattieren. Die pulvermetallurgische Herstellung der eigentlichen Wendeschneidplatten ist mit verschiedenen Nachteilen behaftet, bei Hartmetall sind dies vor allem die Folgenden:
- Zum Erzielen der mit Hinblick auf die mechanische Verschleißfestigkeit wünschenswerten sehr kleinen Korngrößen (der Hartstoffphase, < 0.5 µm) müssen mit hohem Aufwand entsprechend feinkörnige Ausgangspulver erzeugt und möglichst unter Sauerstoffausschluss gehandhabt werden.
- Die Erzeugung porenfreier Sinterkörper mit homogenem Gefüge ist vielfach schwierig, gelingt nicht vollkommen, und erfordert häufig zusätzlichen technischen Aufwand wie heißisostatisches Pressen (engl.: hot isostatic pressing, kurz: HIP).
- Beim Sintern kommt es zu einemKornwachstum, wodurch technisch erstrebenswerte Korngrößen im Nanometer-Bereich nicht erreichbar sind.
- Zahlreiche vielversprechende Materialsysteme (z.B. Legierungen), insbesondere hochwarmfeste, können wegen ihrer hohen Solidustemperaturen nicht oder nicht wirtschaftlich in Gestalt massiver Teile hergestellt werden.
- Die Einstellung spezieller Texturen wie Nanometer-Multilagensysteme ist mit den Mitteln der Pulvermetallurgie entsprechend dem Stand der Technik unmöglich.

Als Nanokomposite werden im Folgenden Werkstoffe bezeichnet, welche aus mindestens zwei (in ihrer Struktur und/oder in ihren physikalischen bzw. chemischen Eigenschaften) unterscheidbaren Phasen besteht, von denen wenigstens eine kristallin vorliegt und einen mittleren Korndurchmesser kleiner 100 nm besitzt.

Im Bereich der Hartstoffbeschichtungen sind seit einigen Jahren Nanokomposite Gegenstand von Forschungen, welche aus einer oder mehreren nanokristallinen (kurz: "nc") Nitridphasen bestehen, die in eine amorphe bzw. röntgenamorphe (kurz: "a") Phase eingebettet sind. Ein Prototyp dieser Nanokomposite ist das Materialsystem nc-TiN/a-Si₃N₄, welches durch herausragende Eindringhärte, hohe Temperaturstabilität, gute chemische Beständigkeit und hohe Oxidationsbeständigkeit gekennzeichnet ist und das in einfacher Weise mit Hilfe üblicher PVD-Verfahren (insbesondere Arc-PVD) hergestellt werden kann.

Die Härte von Nanokompositen dieses Typs kann in einem Bereich liegen, welcher unter den herkömmlichen Schneidstoffen denen auf CBN- und PKD-Basis vorbehalten ist. Dabei werden die höchsten Eindringhärten gefunden, wenn der Volumenanteil der amorphen Phase derart bemessen wird, dass diese an den Korngrenzen der kristallinen Phase(n) überwiegend in lediglich einer Atomlage dicken Schichten präzipitiert. In diesem Fall liegt die amorphe Phase (üblicherweise ein kovalentes Nitrid) tatsächlich weniger amorph als vielmehr epitaktisch vor.

Die der Erfindung zugrunde liegende Aufgabe besteht in der Herstellung einer Wendeschneidplatte mit sehr harter Schneide, die jedoch eine deutlich höhere Zähigkeit aufweist als bekannte, ähnlich harte Schneiden (wie z.B. aus PKD oder CBN).

### Zusammenfassung

Ein Aspekt der vorliegenden Erfindung betrifft eine Wendeschneidplatte umfassend einen Grundkörper mit Freiflächen und zumindest einer Spanfläche gemäß Anspruch 1 und ein Verfahren gemäß Anspruch 11. Gemäß einem Beispiel der Erfindung ist (sind) die Spanfläche(n) der Wendeschneidplatte, nicht jedoch deren Freiflächen, mittels eines PVD-Verfahrens in sehr dicker Schicht (z.B. größer 50 µm) mit einem Hartstoff beschichtet. Als Material für den Grundkörper kommen Hartmetalle, Stellite (also Karbide enthaltende Kobalt-Chrom-Legierungen) oder Schnellarbeitsstähle in Betracht. Als Hartstoff kommt beispielsweise ein Nanokomposit in Frage. Besonders gute Materialeigenschaften (große Zähigkeit bei hoher Härte) können erzielt werden, wenn die Bestandteile der Nanokomposite in abwechselnden dünnen (jeweils kleiner 200 nm) Schichten abgeschieden werden. Derartige in Schichten aufgebaute Nanokomposite werden auch als Nanolaminate bezeichnet.

Ein weiterer Aspekt der Erfindung betrifft ein Verfahren zur Herstellung von Wendeschneidplatten mit den folgenden Schritten: Bereitstellen eines Grundkörpers mit Freiflächen und zumindest einer Spanfläche; Abscheiden einer dicken Schicht aus einem Hartstoff auf der (den) Spanfläche(n) des Grundkörpers mittels eines PVD-Verfahrens, insbesondere einer dicken Schicht aus einem Nanokomposit, beispielsweise einem Nanolaminat. Die Freiflächen werden, abgesehen von an sich unerwünschten und sehr dünnen Ablagerungen nicht mit der dicken PVD-Schicht überzogen.

Als "dicken Schichten" werden Schichten mit einer Schichtdicke von mehr als 50 µm, insbesondere mehr als 100 µm oder sogar mehr als 200 µm bezeichnet. Dicke Schichten haben damit eine deutlich größere Schichtdicke als üblicherweise bei einer Beschichtung von Oberflächen mit Hartstoffen verwendet wird.

Die so erhaltenen Wendeschneidplatten können ähnliche Eindringhärten erreichen wie bekannte PKD- oder CBN-Platten, sind jedoch wesentlich günstiger in der Herstellung. Die bei der Herstellung zur Anwendung kommenden PVD-Verfahren arbeiten mit niedrigen Prozessdrücken und auch mit niedrigeren Temperaturen als die für die Herstellung von PKD oder CBN in Frage kommende HPHT-Verfahren. Des Weiteren ist keine aufwändige Vereinzelung der Schneidplättchen notwendig und das Auflöten bzw. Aufsintern der eigentlichen Schneidplättchen auf den Grundkörper entfällt.

Ein weiterer Vorteil liegt in der großen Auswahl an unterschiedlich zusammengesetzten nc/a-Nanokompositen, wodurch eine Abstimmung des Schneidstoffs auf den zu bearbeitenden Werkstoff bezüglich der chemischen Verträglichkeit von Schneidstoff und Werkstoff ermöglicht. Zudem verfügen die derart mittels PVD-Verfahren hergestellte Nanokomposite bzw. Nanolaminate eine große Zähigkeit aufgrund von verfahrensbedingten Druckeigenspannungen. Im Gegensatz dazu weisen mittels CVD hergestellte Schichten in der Regel Zug- statt Druckeigenspannungen auf und sind daher spröder.

Insbesondere PVD-Nanolaminate können makroskopisch nahezu eigenspannungsfrei und dennoch außerordentlich zäh sein. Dies ist zurückzuführen auf lokal auftretende Druckspannungen, welche aus Fehlanpassungen zwischen den unterscheidbaren Lagen resultieren, und die die Bildung von Rissen verhindern oder deren Ausbreitung sehr wirksam unterdrücken.

Zusätzlich zu der hohen Zähigkeit können Wendeschneidplatten gemäß dem oben genannten Beispiel der Erfindung eine im Vergleich zu herkömmlichen Wendeschneidplatten verbesserte Warmfestigkeit aufweisen. Selbst bei einer Erhöhung der Temperatur während eines Schneidvorganges auf mehr als 800 °C. verliert die PVD-Schicht, welche die Schneide bildet, kaum an Härte. Wie bei den bekannten aufgelöteten CBN- bzw. PKD-Schneidplättchen sind die erfindungsgemäß als PVD-Schichten ausgebildete Schneiden der Wendeschneidplatten wegen ihrer großen Schichtdicke nahezu freitragend, wodurch die Anforderungen an Warmfestigkeit und Härte des Grundkörpers relativ gering sind. Die PVD-Schicht verteilt die beim Zerspanen auftretenden Kräfte flächig auf den Grundkörper, wodurch dieser nur geringe Drücke spürt.

### Kurzbeschreibung der Abbildungen

Die folgenden Figuren und die weitere Beschreibung soll helfen, die Erfindung besser zu verstehen. Nähere Details, Varianten und Weiterentwicklungen des Erfindungsgedankens werden an Hand von Figuren erläutert, die ein spezielles ausgewähltes Beispiel betreffen. Die Elemente in den Figuren sind nicht unbedingt als Einschränkung zu verstehen, vielmehr wird Wert darauf gelegt, das Prinzip der Erfindung darzustellen. In den Figuren bezeichnen gleiche Bezugszeichen korrespondierende Teile.
- Fig. 1: zeigt einen schematischen Querschnitt (nicht maßstabsgetreu) durch eine gemäß einem Beispiel der Erfindung aufgebaute Wendeschneidplatte;
- Fig. 2: zeigt in einer schematischen Draufsicht (nicht Maßstabsgetreu) einer Anordnung zur PVD-Beschichtung von an einem rotierenden Werkstückträger angeordneten Wendeschneidplatten-Grundkörpern;
- Fig. 3: zeigt einen Ausschnitt aus Fig. 2 in vergrößerter und detaillierterer Darstellung; und
- Fig. 4: zeigt die Wendeschneidplatte aus Fig. 1 in verschiedenen Stadien eines Herstellungsverfahrens gemäß einem Beispiel der Erfindung.

### Detaillierte Beschreibung

Gemäß einem Beispiel ist (sind) die Spanfläche (n) einer Wendeschneidplatte, nicht jedoch deren Freiflächen, mittels eines PVD-Verfahrens in sehr dicker Schicht (z.B. größer 50 µm) mit einem Hartstoff beschichtet. Als Material für den Grundkörper können übliche Werkstoffe, wie z.B. Hartmetalle, Stellite oder Schnellarbeitsstähle, verwendet werden.

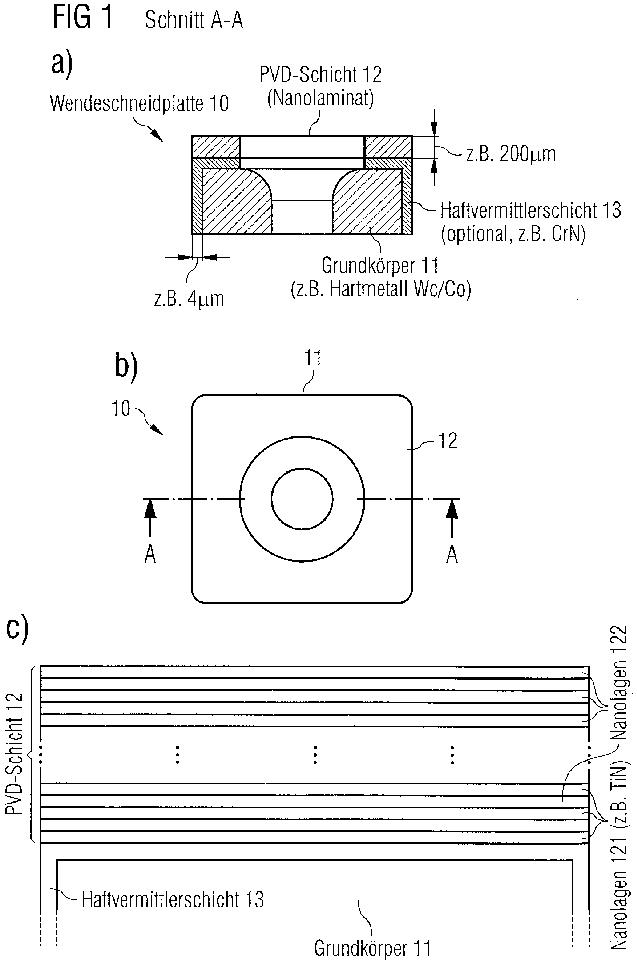

Fig. 1 illustriert eine Wendeschneidplatte 10 gem. einem Beispiel, wobei in Fig. 1b eine Draufsicht und in Fig. 1a eine korrespondierende Schnittdarstellung zu sehen ist. In dem vorliegenden Beispiel umfasst die Wendeschneidplatte 10 einen quaderförmigen Schneidplatten-Grundkörper 11 aus Hartmetall (z.B. WC/Co). Der Grundkörper hat eine quadratische Grundfläche (Seitenlänge z.B. 12,7 mm) und eine Höhe (Dicke), die deutlich kleiner ist, als die Seitenlänge der Grundfläche (z.B. 3,18 mm), sowie ein zentrales Durchgangsloch, das zur Oberseite hin weiter wird. Die Abmessungen der Wendeschneidplatten sind vielfach genormt. Die Grundformkann folglichauch von der in Fig. 1 gewählten Darstellung abweichen. Insbesondere sind auch Wendeschneidplatten mit dreieckiger Grundfläche sowie Wendeschneidplatten ohne Durchgangsloch bekannt.

Wie eingangs erwähnt weisen herkömmliche Wendeschneidplatten häufig Schneiden (Schneidplättchen) aus Hartstoffen (z.B. CBN) auf, die aufwändig hergestellt werden und anschließend auf den Grundkörper aufgelötet oder aufgesintert (Sinter-Fusing) werden müssen. Im Gegensatz dazu ist bei der in Fig. 1 dargestellten Wendeschneidplatte 10 eine dicke PVD-Schicht 12 aus einem Hartstoff auf einer Spanfläche des Grundkörpers 11 angeordnet. Die Freiflächen des Grundkörpers 11 weisen keine dicke PVD-Schicht 12 auf. Als PVD-Schichten werden als dick bezeichnet wenn sie deutlich dicker sind als übliche Beschichtungen von Schneiden. Als unterer Grenzwert für die Dicke einer dicken PVD-Schicht 12 kann 50 µm angegeben werden, im vorliegenden Beispiel beträgt die Dicke der PVD-Schicht 12, welche die Schneide der Wendeschneidplatte 10 bildet, ca. 200µm. Optional kann der Grundkörper 11 aus Hartmetall noch (zumindest teilweise) mit einer Haftvermittlerschicht 13 (z.B. aus Chrom- oder Zirkoniumnitrid) überzogen sein. Diese Schicht 13 ist mit rund 4 µm wesentlich dünner als die dicke PVD-Schicht 12 und kann auch auf den Freiflächen des Grundkörpers angeordnet sein.

Als "Freiflächen" des Grundkörpers werden im Beispiel gemäß Fig. 1 die Seitenflächen des quaderförmigen Grundkörpers 11 sowie dessen Unterseite bezeichnet. Die "Spanfläche" ist die Oberseite des Grundkörpers 11. Auch bei einem Grundkörper mit dreieckiger Grundfläche könnte dessen Oberseite als Spanfläche und die drei Seitenflächen sowie die Unterseite als Freiflächen bezeichnet werden. Allgemein ist die Spanfläche jene Fläche eines Grundkörpers, welche die Schneide bzw. das Schneidplättchen trägt.

Die Folgende Beschreibung befasst sich im Wesentlichen mit dem Material der dicken PVD-Schicht 12, deren innerer Struktur. Beispielsweise zeigt Fig. 1c die PVD-Schicht 12 aus Fig. 1a als Stapel ("Stack") einer Vielzahl von abwechselnd angeordneter Nanolagen mit Dicken im unteren Nanometerbereich. Im Anschluss folgt eine Diskussion eines Herstellungsverfahrens gemäß einem Beispiel der Erfindung.

Als PVD-Verfahren zum Beschichten der Spanfläche eines Wendeschneidplatten-Grundkörpers kann z.B. Lichtbogenverdampfen (Arc-PVD) zumEinsatz kommen. Nachdem Abscheiden kann, gemäß einem Beispiel der Erfindung, der Hartstoff ganz oder überwiegend in nanokristalliner Form vorliegen. Die Kristallisation ist vor allem von den Prozessparametern (Bias-Spannung, Prozessdruck und Temperatur) des verwendeten PVD-Verfahrens abhängig und kann abhängig vom verwendeten Material experimentell ermittelt werden.

Nanokomposit: Eine besonders harte und gleichzeitig zähe Schicht kann erzielt werden, wenn die abgeschiedene Hartstoffschicht ein Nanokomposit ist, welches ganz oder überwiegend aus Nitriden bestehen kann. Insbesondere kann das Nanokomposit überwiegend aus zumindest einer kristallinen Phase bestehen sowie aus zumindest einer amorphen bzw. epitaktischen Phase. Der Stoffmengenanteil der amorphen bzw. epitakitschen Phase(n) liegt beispielsweise zwischen 2 Mol-% und 20 Mol-% liegt. Die kristalline (n) Phase (n) wird (werden) beispielsweise aus einem oder mehreren kristallinen Nitriden gebildet. Insbesondere können die kristalline (n) Phase (n) ganz oder überwiegend aus TiN, ZrN, HfN, TaN oder CrN bestehen und die amorphe(n) bzw. epitakitsche(n) Phase (n) aus Siliziumnitrid (Si₃N₄) und/oder Bornitrid (BN). In kristallinen Phasen können die oben genannten Stoffe (TiN, ZrN, HfN, TaN oder CrN) auch als Legierung mit Aluminiumnitrid vorliegen (z.B. TiN-AlN und CrN-AlN). Die nanokristallinen Phasen sind (z.B. nc-CrN) in einer Matrix aus amorphem bzw. epitakischem Siliziumnitrid (a-Si₃N₄-Matrix) oder Bornitrid gleichsam eingebettet.

Nanolaminat: Gute Materialeigenschaften (große Zähigkeit bei hoher Härte) der Wendeschneidplatte können erzielt werden, wenn die Nanokomposite und/oder deren Komponenten abwechselnden in dünnen Lagen abgeschieden werden (z.B. jeweils dünner als 200 nm, insbesondere dünner als 100 nm) . Derartige aus unterscheidbaren Lagen aufgebaute Nanokomposite werden auch als Nanolaminate bezeichnet. Beispielsweise kann ein Nanolaminat dadurch gebildet werden, dass abwechselnd eine (nanokristalline) Nitrid-Lage bestehend aus TiN, ZrN, HfN, TaN, CrN oder einer Legierung aus zumindest zwei der vorgenannten Stoffe und eine Nanokomposit-Lage wie bereits weiter oben beschrieben abgeschieden wird. Die Nitrid-Lagen weisen dabei eine Dicke von beispielsweise 5 nm bis 20 nm auf, die Nano-Kompositlagen eine Dicke von beispielsweise 20 nm bis 60 nm.

Besonders gute Materialeigenschaften der Wendeschneidplatte können mit Nanolaminaten erzielt werden, die abwechselnd Nitrid-Lagen und Nanokomposit-Lagen aufweisen. Die Nitrid-Lagen bestehen dabei z.B. ganz oder überwiegend aus nanokristallinem Titannitrid (nc-TiN) und die Nanokomposit-Lagen ganz oder überwiegend aus einer Matrix aus amorphem (bzw. eptitaktischem) Siliziumnitrid, in die eine nanokristalline Aluminiumnitrid-Chromnitrid-Lösung eingebettet ist (z.B. nc-(AlN-CrN)/a-Si₃N₄). Wie oben erwähnt beträgt der Stoffmengenanteil des amorphen/epitaktischen Si₃N₄ zwischen 2 Mol-% und 20 Mol-%.

Im Rahmen von Experimenten hat sich herausgestellt, dass die Eigenschaften des Nanolaminats besser sind, wenn die nanokristallinen Phasen des Nanokomposits (im obigen Beispiel nc-AlN-CrN) möglichst keine Phase mit hexagonaler Kristallstruktur enthält. Folglich sind, ganz allgemein und nicht nur bei Nanolaminaten, im Nanokomposit ausschließlich Kristallite mit kubischer Struktur wünschenswert. Um eine in diesem Sinne gute Kristallstruktur zu erreichen, können die Prozessparameter (Temperatur, Druck und Bias-Spannung) des PVD-Beschichtungsprozesses sowie die Legierungsanteile der nanokritallinene Phase des Komposits (AlN und CrN im obigen Beispiel) derart eingestellt werden, dass möglichst wenige (bestenfalls keine) Kristallite hexagonaler Struktur im Komposit gebildet werden. Abhängig von den konkret verwendeten Stoffen, können die optimalen Prozessbedingungen und Legierungsverhältnisse experimentell ermittelt werden. Im erläuterten Beispiel eines Nanolaminates mit abwechselnden Nitrid-Lagen aus nc-TiN und Nanokomposit-Lagen aus nc-(AlN-CrN)/a-Si₃N₄ wurden sehr hohe Eindringhärten und hohe Zähigkeit erreicht, wenn der Anteil an AlN in der AlN-CrN-Lösung gerade so hoch ist, dass sich (noch) keine hexagonalen, sondern fast ausschließlich kubische Kristallstrukturen bilden. Ein höherer AlN-Anteil hätte einen nennenswerten Anteil an hexagonalen Kristalliten zur Folge, und das Material würde spröde. Bei einem Verhältnis von 70 Mol-% AlN zu 30 Mol% CrN ist Experimenten zufolge obige Bedingung erfüllt und das resultierende Nanolaminat besonders hart und zäh. Der hohe AlN-Anteil bewirkt außerdem einen kleinen thermischen Ausdehnungskoeffizienten bei gleichzeitig hoher Wärmeleitfähigkeit des Nanolaminats.

Gemäß einem Beispiel der Erfindung abgeschiedene Nanolaminat-Schichten mit Lagen aus nc-Aln-CrN und TiN stehen nur unter geringen makroskopischen Eigenspannungen und sind sehr zäh und glatt. Ist die nc-Aln-CrN-Lösung eingebettet in eine α-Si₃N₄-Matrix, steigt die Härte der Nanolaminat-Schicht sehr stark an ohne an Zähigkeit zu verlieren. Gute Materialeigenschaften erhält man bei einem Stoffanteil zwischen 2 Mol-% und 10 Mol-% a-Si₃N₄ in der nc-(AlN-CrN)/a-Si₃N₄-Nanokomposit-Lage, insbesondere bei 5 Mol-%. Die Dicke der nc-TiN-Nitrid-Lagen liegt dabei zwischen 5 nm und 20nm, die Dicke der nc- (AlN-CrN)/a-Si₃N₄-Nanokomposit-Lagen zwischen 40 nm und 60 nm. Derartige Nanolaminate sind elektrisch leitfähig und können bei Bedarf durch Funkenerodieren bearbeitet werden.

Wie bereits beschreiben können durch Abscheiden von Hartstoffen in Form von Nanolaminaten auf einer Spanfläche eines Schneidplatten-Grundkörpers Wendeschneidplatten mit extrem harten und dennoch zähen Schneidenhergestellt werden. Zur weiteren Steigerung der Zähigkeit sowie zur Anpassung des (makroskopischen) thermischen Ausdehnungskoeffizienten an den des Schneidplatten-Grundkörpers können zwischen den Lagen des oben beschriebenen Nanolaminats weitere Lagen (Zwischenlagen) aus anderen Werkstoffen, insbesondere weitere Lagen aus Siliziumnitrid und/oder aus Metallen, die keine stabilen Nitride bilden, eingefügt werden. Die Dicke dieser Zwischenlagen beträgt beipsielsweise 5 nm bis 200 nm. Der Volumenanteil der weiteren Lagen an der gesamten abgeschiedenen Schicht ist dabei beispielsweise kleiner oder gleich 50% Die Zwischenlagen trennen dabei Stapel ("stacks") aus mehreren Nano-Lagen (Lagen aus nc-TiN sowie nc-(AlN-CrN)/a-Si₃N₄) mit einer Gesamtdicke vom beispielsweise 1 µm bis 3 µm. Gute Ergebnisse wurden erzielt mit Laminat-Stapeln mit Dicken von rund 2 µm und dazwischen liegenden metallischen Zwischenlagen mit Dicken von rund 10 nm.

Wie erwähnt, können die weiteren Lagen (Zwischenlagen) durch Abscheiden von nicht-nitridbildenden Metallen oder deren Legierungen gebildet werden. Hierzu kommen beispielsweise Eisenmetalle (also Eisen, Kobalt und/oder Nickel) und Rhenium sowie deren Legierungen in Betracht. Des Weiteren sind Nickel-Kobalt-Legierungen als Werkstoff für die Herstellung der Zwischenlagen geeignet, insbesondere eine Legierung mit ungefähr gleichen Anteilen (Mol-%) an Kobalt und Nickel, optional mit einem Rhenium-Anteil von 2 Mol-% bis 12 Mol-%. Zusätzlich oder alternativ kann die Nickel-Kobalt-Legierung bis zu 2 Mol-% eines nitridbildenden Übergangsmetalls (in Form von Nitrid) enthalten, wobei das nitridbildende Übergangsmetall der Kornfeinung dient. Alternativ können die Zwischenlagen durch Abscheiden von texturierten Lagen aus (nanokristallinem) Siliziumnitrid erzeugt werden, wodurch neben einer Steigerung der Zähigkeit auch eine Verbesserung der Temperaturwechselbeständigkeit (durch Reduktion des makroskopischen thermischen Ausdehnungskoeffizienten) bewirkt wird. Die Steigerung der Zähigkeit ist in diesem Fall zwar nicht so groß wie bei metallischen Zwischenlagen, jedoch ist der Adhäsionsverschleiß beim Bearbeiten niedrig legierter Stähle geringer.

Unabhängig von der Wahl des Werkstoffes für die Zwischenlagen kann durch ein Variieren des Verhältnisses der Dicke der Zwischenlagen zur Dicke des jeweils darauffolgenden Nanolaminat-Stapels der thermische Ausdehnungskoeffizient über die Gesamtdicke der abgeschiedenen Schicht quasi kontinuierlich angepasst werden. An der dem Schneidplatten-Grundkörper zugewandten Seite der abgeschiedenen Schicht ist dabei der Volumenanteil der Zwischenlagen am höchsten zu wählen, wobei mit zunehmendem Abstand vom Grundkörper der Volumenanteil abnimmt.

Eine gemäß einem der oben beschriebenen Beispiele der Erfindung aufgebaute Wendeschneidplatte kann nach dem Abscheiden der dicken PVD-Schicht in an sich bekannter Weise mit einer (im Vergleich zur dicken PVD-Schicht) dünnen tribologischen Schicht bzw. einem Hartstoff beschichtet werden. Unter tribologischen Schichten werden allgemein alle Schichten verstanden, die den abrasiven Verschleiß vermindern. Diese Beschichtung kann auch auf die Freiflächen der Wendeschneidplatte aufgetragen werden, im Gegensatz zu der dicken PVD-Schicht aus Nanokomposit oder Nanolaminat, welche die Schneide bildet. Die Dicke derartiger der tribologischer Schichten beträgt üblicherweise ca. 1 µm bis 12 µm.

Zusätzlich oder alternativ kann der Schneidplatten-Grundkörper vor dem Abscheiden der dicken PVD-Schicht, welche die Schneide bildet, mit einem bekannten Hartstoff beschichtet werden. Diese zusätzliche Schicht ist dünner als die dicke PVD-Schicht, welche anschließend auf dieser zusätzlichen Schicht abgeschieden wird. Die zusätzliche Schicht kann die Funktion einer Haftvermittlerschicht erfüllen. Zu diesem Zweck kann vor dem Abscheiden der dicken PVD-Schicht eine Haftvermittlerschicht auf den Grundkörper aufgebracht werden, die beispielsweise ganz oder teilweise aus Chromnitrid (CrN), Titannitrid (TiN) oder Zirkoniumnitrid (ZrN) oder einer entsprechenden Legierung besteht. Das Vorsehen von Haftvermittlerschichten und tribologischen Schichten ist nicht auf die Ausführungsbeispiele die Schneidplättchen aus Nanolaminat betreffen beschränkt.

sp³-hybridisierter Kohlenstoff: Alternativ zu dem oben beschriebenen Nanokomposit oder Nanolaminat eignet sich als Hartstoff beispielsweise auch sp³-hybridisierter Kohlenstoff oder sp³-hybridisiertes Bornitrid, das z.B. mittels gefiltertem Lichtbogenverdampfen (Arc-PVD) oder Kathodenzerstäubung (Sputtern) in dicken Schichten auf der Spanfläche eines Schneidplatten-Grundkörpers abgeschieden werden kann. Im Gegensatz zu bekannten CVD-Schichten sind derartige dicke Schichten (z.B. Dicke größer als 50 µm) weniger spröde und müssen nicht vereinzelt und aufgelötet (oder aufgesintert) werden.

Der Hybridisierungsgrad kann dabei während der Abscheidung periodisch verändert werden, beispielsweise durch Modulation der Bias-Spannung. Auf diese Art entsteht ein Laminat aus einer Vielzahl von Lagen mit Schichtdicken im Nanometerbereich mit unterschiedlichem Hybridisierungsgrad, wobei mindestens eine Lage ganz oder überwiegend sp³-hybridisiert vorliegt. Ein solches Laminat kann als Nanolaminat bezeichnet werden. Ein anderer Typ Nanolaminat wird weiter untern beschrieben. Es kann auch Kohlenstoff und Bornitrid (als Nanolaminat oder als dicke Einzelschicht) abgeschieden werden. In diesem Fall werden gute Ergebnisse erzielt, wenn zumindest eine Phase ganz oder überwiegend sp³-hybridisiert vorliegt. Zwischen den einzelnen Lagen können Zwischenschichten eingefügt werden, insbesondere aus Metallen und Legierungen, die keine stabilen Nitride oder Carbide bilden. Betreffend die Zwischenschichten gilt auch hier das weiter oben im Zusammenhang mit dem Nanokomposit-Nanolaminat Beschriebene. Derartige Wendeschneidplatten eignen sich besonders gut zum Fräsen oder Drehen von Titan und Titanlegierungen (z.B. TiAl₄V₆).

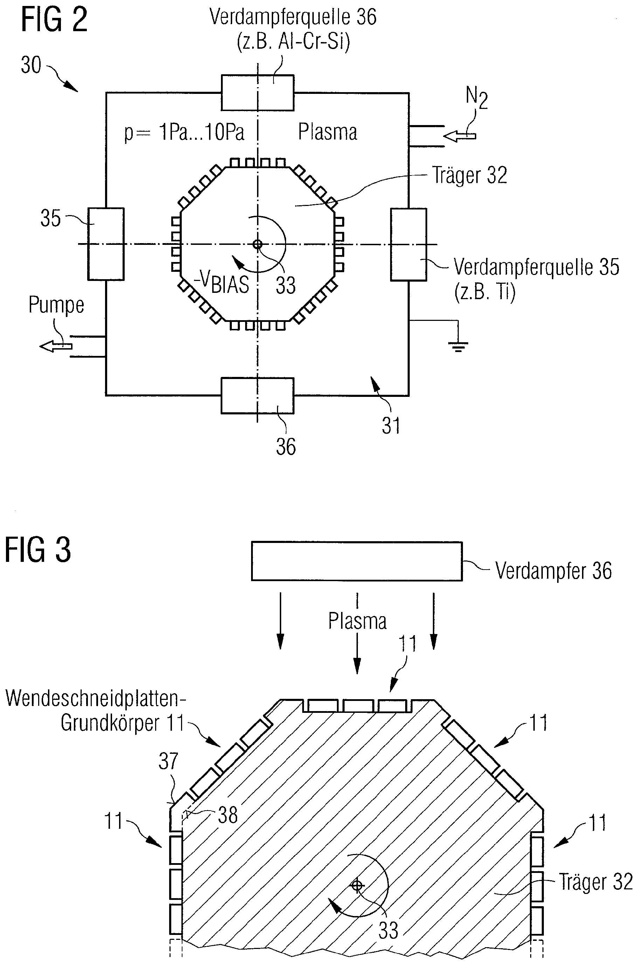

Im Folgenden werden verschiedene Aspekte eines Verfahrens zur Herstellung der oben beschriebenen und in Fig. 1 skizzierten Wendeschneidplatten anhand der Fig. 2 bis 4 erläutert. Gemäß einem Beispiel umfasst ein Verfahren zur Herstellung von Wendeschneidplatten 10 die folgenden Schritte: Bereitstellen eines oder mehrerer Grundkörper 11 mit Freiflächen und jeweils einer Spanfläche; Abscheiden einer dicken Schicht 12 aus einem Hartstoff mittels eines PVD-Verfahrens, insbesondere einer dicken Schicht aus einem Nanokomposit, beispielsweise einem Nanolaminat. Wie bereits erläutert werden unter dicken PVD-Schichten Schichten mit Dicken von mindestens 50 µm, typischerweise 200 µm oder mehr, verstanden.

Fig. 2 illustriert in einer schematischen Darstellung eine Draufsicht ins Innere einer PVD-Prozesskammer. In deren Mitte ist ein rotierbarer Werkstückträger 32 an zentraler Stelle angeordnet ist (Drehachse 33) . Im vorliegenden Beispiel hat ein Querschnitt (normal zur Drehachse 33) durch den Werkstückhalter 32 eine achteckige Kontur, es sind jedoch auch andere Formen möglich. Um den Werkzeugträger 32 sind mehrere Verdampfer 35, 36 (in manchen PVD-Verfahren auch als "Targets" bezeichnet) angeordnet, im vorliegendenBeispiel sind vier Verdampfer vorgesehen, die in Bezug auf die Drehachse 33 jeweils um 90° versetzt angeordnet sind in jeweils gleichem Abstand zur Drehachse.

Zwei gegenüberliegende Verdampfer sind jeweils dazu ausgebildet, einen bestimmten abzuscheidenden Stoff zur Verfügung zu stellen. Im Beispiel aus Fig. 2 beinhalten die Verdampfer 36 eine Legierung aus Aluminium, Chrom und Silizium, welche in der Stickstoffatmosphäre der PVD-Prozesskammer 30 zu entsprechenden Nitriden reagiert und als Nanokomposit nc-AlN-CrN/a-Si₃N₄ auf den Spanflächen der auf der Mantelfläche des Werkstoffträgers 33 montierten Wendeschneidplatten-Grundkörper 11 abgeschieden wird. In ähnlicher Weise beinhalten die Verdampfer 35 Titan, das in der Stickstoffatmosphäre der PVD-Prozesskammer 30 zu Titannitrid reagiert, das wie weiter oben beschrieben auf dem Wendeschneidplatten-Grundkörper 11 als nc-TiN abgeschieden wird.

Wie weiter oben bereits erwähnt ist es wünschenswert wenn die nanokristallinen Phasen der TiN-Lagen und/oder der Nanokomposit-Lagen möglichst ausschließlich Kristalliten kubischer Kristallstruktur aufweisen und hexagonale Kristallstrukturen vermieden werden sollten. Um das zu erreichen können die Prozessparameter des PVD-Prozesses, insbesondere der Druck und die Temperatur der Stickstoffatmosphäre sowie die Bias-Spannung V_{BIAS} des Werkstückträgers 33 (und damit der Grundkörper 11) so eingestellt werden, dass eben keine hexagonale Kristallstrukturen in der PVD-Schicht gebildet werden. Die optimalen Parameter können experimentell ermittelt werden. In ähnlicher Weise kann das Legierungsverhältnis der Al-Cr-Si-Verdampfer 36 derart angepasst werden, dass gerade keine hexagonale Kristallstrukturen in der PVD-Schicht gebildet werden. Bei sukzessiver Erhöhung des Aluminium-Anteils werden die Kristalle ab einem gewissen kritischen Anteil an Aluminium hexagonal. Gute Materialeigenschaften wurden erzielt, wenn das Legierungsverhältnis nahe diesem Punkt gewählt wurde, ohne jedoch hexagonale Kristallstrukturen zuzulassen.

Im vorliegenden Beispiel wurde ein Arc-PVD-Prozess eingesetzt, die Drücke im Innenraum der Prozesskammer 30 lagen im Bereich von 1 Pa bis 10 Pa, die Prozesskammer ist geerdet und die Bias-Spannung des Werkstückträgers liegt im Bereich von -80 V bis -900 V, insbesondere -400 V.

Die Fig. 3 zeigt einen Ausschnitt aus Fig. 2 in vergrößerter und detaillierterer Darstellung, nämlich den Werkstückträger 32 inklusiver mit montierten Wendeschneidplatten-Grundkörpern 11 und einen der Verdampfer 36. PVD-Verfahren haben - bei geeigneten Prozessbedingungen (Temperatur, Druck Bias-Spannung, etc) prinzipbedingt eine bevorzugte Abscheiderichtung, d.h. die PVD-Schicht "wächst" stärker entlang der "Sichtline" vom Verdampfer zur Drehachse 33 des Werkstückträgers als in andere. Um zu erreichen, dass die Freiflächen der Grundkörper 11 (abgesehen von unerwünschten Ablagerungen) möglichst nicht beschichtet werden, werden die einzelnen Grundkörper in einer Vertiefung in einer zur AußenKontur 37 des Werkstückträgers 32 zurückgesetzten Ebene (parallel zur Drehachse 33) jeweils in nur geringem Abstand zueinander montiert. Dieser geringe Abstand ist geringfügig größer als die angestrebte Schichtdicke der PVD-Schicht, z.B. nicht mehr als 50 % größer als das Doppelte der angestrebten Schichtdicke. Die direkt am Rand der Vertiefung angeordneten Grundkörper sind von diesem Rand ebenfalls nicht weiter entfernt als die Grundkörper zueinander beabstandet sind.

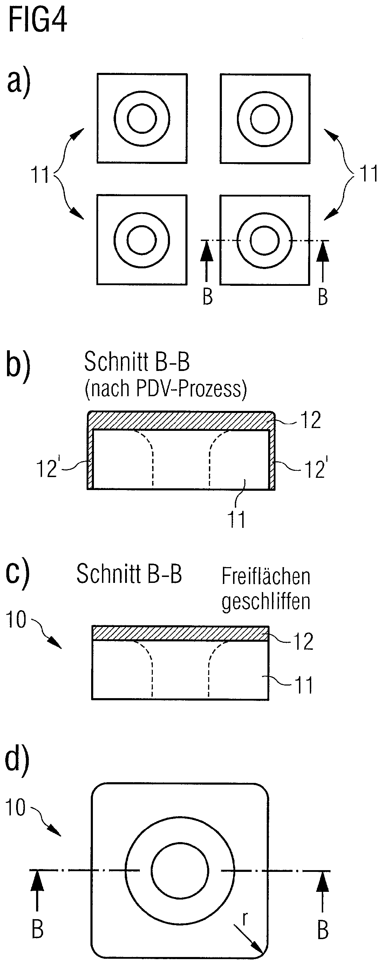

Fig. 4 fasst beispielhaft wichtige Aspekte des Herstellungsverfahrens in den Darstellungen (a) bis (e) zusammen. Fig. 4a zeigt mehrere Wendeschneidplatten-Grundkörper 11 in regelmäßiger, eng beabstandeter Anordnung, wie sie z.B. auf einem Werkstückträger vor der PVD-Beschichtung angeordnet sind. Die enge Anordnung verhindert größere Ablagerungen an den Seitenflächen (Freiflächen) der Grundkörper 11.

Fig. 4b zeigt eine Wendeschneidplatte 10 mit Grundkörper 11 und darauf abgeschiedenen PVD-Schicht 12 im Querschnitt, wobei an den Seitenflächen geringfügige Ablagerungen 12' (wenige µm dick) vorhanden sind. Nicht nur, um diese Ablagerungen 12' zu entfernen, sondern auch um den (Schneid-) Kanten der Wendeschneidplatte eine definierte Form zu geben, können die Freiflächen der Grundkörper 11 geschliffen werden. Fig. 4c zeigt die Wendeschneidplatte 10 aus Fig. 4b nach dem Schleifen der Freiflächen. Figur 4d eine entsprechende Draufsicht. Durch das Schleifen haben die Seitenkanten einen definierten Radius erhalten und die PVD-Schicht 12 entlang ihrer oberen Längskante eine scharfe Schneide.

Im Anschluss kann, wie weiter oben bereits erwähnt die Wendeschneidplatte ganz oder teilweise mit einer tribologischen Schicht überzogen werden. Optional kann der Grundkörper vor dem Abscheiden der PVD-Schicht mit einer Haftvermittlerschicht beschichtet werden (vgl. Schicht 13 aus Fig. 1).

Die oben beschrieben Aspekte des Herstellungsverfahrens sind unabhängig von der konkreten Form des Grundkörpers und der konkreten Zusammensetzung der PVD-Schicht.

## Patentansprüche

1. Wendeschneidplatte (10) umfassend einen Grundkörper (11) mit Freiflächen und zumindest einer Spanfläche,
**dadurch gekennzeichnet, dass** die Spanfläche(n) des Grundkörpers (11), nicht jedoch deren Freiflächen, mittels eines PVD-Verfahrens mit einer PVD-Schicht (12), deren Schichtdicke größer als 50 µm ist, aus einem Hartstoff beschichtet ist,
wobei der Hartstoff in Form eines Nanolaminats vorliegt, das eine Vielzahl von unterscheidbaren Lagen (122) umfasst.

2. Wendeschneidplatte (10) nach Anspruch 1, wobei die Schichtdicke der PVD-Schicht (12) größer als 100 µm ist, insbesondere größer als 150 µm oder größer als 200 µm ist.

3. Wendeschneidplatte (10) nach Anspruch 1 oder 2,
wobei der Hartstoff in der PVD-Schicht (12) ganz oder überwiegend nanokristallin, insbesondere in kubischer Kristallstruktur vorliegt.

4. Wendeschneidplatte (10) nach einem der Ansprüche 1 bis 3,
wobei der Hartstoff ein Nanokomposit ist, welches ganz oder überwiegend aus Nitriden gebildet ist.

5. Wendeschneidplatte (10) nach Anspruch 1 oder 2, wobei die unterscheidbaren Lagen (122) des Nanolaminats aus unterschiedlichen Nitriden gebildet sind.

6. Wendeschneidplatte (10) nach einem der Ansprüche 1 bis 5, wobei die Wendeschneidplatte (10) einschließlich der PVD-Schicht (12) zusätzlich mit zumindest einer tribologischen Schicht überzogen ist.

7. Wendeschneidplatte (10) nach Anspruch 6, wobei auch die Freiflächen des Grundkörpers (11) überzogen sind.

8. Wendeschneidplatte (10) nach einem der Ansprüche 1 bis 7, wobei zwischen dem Grundkörper (11) und der PVD-Schicht (12) eine zusätzliche Schicht aus Hartstoff angeordnet ist.

9. Wendeschneidplatte (10) nach Anspruch 8, wobei die zusätzliche Schicht aus einem derartigen Material besteht, dass sie als Haftvermittlerschicht (13) zwischen der PVD-Schicht (12) und dem Grundkörper (11) wirkt.

10. Wendeschneidplatte (10) nach Anspruch 9, wobei die zusätzliche Beschichtung (13) ganz oder teilweise aus CrN besteht.

11. Verfahren zur Herstellung von Wendeschneidplatten (10), umfassend die folgenden Schritte:
Bereitstellen von Schneidplatten-Grundkörpern (11) mit Freiflächen und jeweils zumindest einer Spanfläche;
Abscheiden einer dicken Schicht (12) von mindestens 50 µm aus einem Hartstoff mittels eines PVD-Verfahrens auf die Spanflächen der Grundkörper (11), wobei der Hartstoff in Form eines Nanolaminats vorliegt, das eine Vielzahl von unterscheidbaren Lagen (122) umfasst.

12. Verfahren nach Anspruch 11, bei dem das Abscheiden solange erfolgt, bis die PVD-Schicht (12) größer als 100 µm ist, insbesondere größer als 150 µm oder größer als 200 µm ist.

13. Verfahren gemäß Anspruch 11 oder 12, bei dem
während des Abscheidens der PVD-Schicht (12) die Grundkörper (11) in einer PVD-Prozesskammer mit mindestens einer Verdampferquelle (35, 36) angeordnet sind und
die Grundkörper (11) relativ zu der Verdampferquelle (35, 36) bzw. zu einer der Verdampferquellen (35, 36) derart angeordnet sind, dass fast ausschließlich die Spanflächen der Grundkörper (11) beschichtet werden.

14. Verfahren gemäß einem der Ansprüche 11 bis 13, bei dem vor dem Abscheiden der PVD-Schicht (12) der Grundkörper (11) zumindest teilweise mit einer Haftvermittlerschicht (13), insbesondere einer Schicht aus CrN, ZrN, TiN oder einer Legierung der vorgenannten Stoffe, überzogen wird, worauf die Abscheidung der PVD-Schicht (12) auf die Haftvermittlerschicht (13) erfolgt.

15. Verfahren gemäß einem der Ansprüche 11 bis 14, bei dem die Prozessparameter, insbesondere Temperatur, Atmosphärendruck und Bias-Spannung, derart eingestellt werden, dass in den kristallinen Phasen in der PVD-Schicht (12) möglichst keine hexagonale Kristallite sondern ausschließlich kubische Kristallite gebildet werden.

## Claims

1. Indexable insert (10) comprising a base body (11) having free surfaces and at least one cutting surface,
**characterized in that** the cutting surface(s) of the base body (11), but not the free surfaces, are coated by a PVD process with a PVD layer (12) made of a hard material and having a layer thickness greater than 50 µm,
wherein the hard material is a nanolaminate comprising a plurality of distinguishable layers (122).

2. Indexable insert (10) according to claim 1, wherein the layer thickness of the PVD layer (12) is greater than 100 µm, in particular greater than 150 µm or greater than 200 µm.

3. Indexable insert (10) according to claim 1 or 2,
wherein the hard material in the PVD layer (12) is entirely or predominantly nanocrystalline, in particular has a cubic crystalline structure.

4. Indexable insert (10) according to one the claims 1 to 3,
wherein the hard material is a nanocomposite which is composed entirely or predominantly of nitrides.

5. Indexable insert (10) according to claim 1 or 2, wherein the distinguishable layers (122) of the nanolaminates are composed of different nitrides.

6. Indexable insert (10) according to one of the claims 1 to 5, wherein the indexable insert (10) including the PVD layer (12) is further coated with at least one tribological layer.

7. Indexable insert (10) according to claim 6, wherein the free surfaces of the base body (11) are also coated.

8. Indexable insert (10) according to one of the claims 1 to 7, wherein an additional layer made of hard material is arranged between the base body (11) and the PVD layer (12).

9. Indexable insert (10) according to claim 8, wherein the additional layer is made of such a material that it functions as an adhesion promoting layer (13) between the PVD layer (12) and the base body (11).

10. Indexable insert (10) according to claim 9, wherein the additional coating (13) is made entirely or predominantly of CrN.

11. Method for producing indexable inserts (10), comprising the following steps:
providing indexable insert base bodies (11) having free surfaces and at least one cutting surface;
depositing a thick layer (12) of at least 50 µm and made of a hard material on the cutting surfaces of the base bodies (11) by a PVD process, wherein the hard material is a nanolaminate comprising a plurality of distinguishable layers (122).

12. Method according to claim 11, wherein the deposition is carried out until the PVD layer (12) is greater than 100 µm, in particular greater than 150 µm or greater than 200 µm.

13. Method according to claim 11 or 12, wherein
during the deposition of the PVD layer (12) the base bodies (11) are arranged in a PVD process chamber having at least one evaporator source (35, 36) and
the base bodies (11) are arranged relative to the evaporator source (35, 36) or to the evaporator sources (35, 36) such that almost exclusively the cutting surfaces of the base bodies (11) are coated.

14. Method according to one of the claims 11 to 13, wherein before the deposition of the PVD layer (12) the base body (11) is coated at least in part with an adhesion promoting layer (13), in particular a layer made of CrN, ZrN, TiN or another alloy of the aforementioned materials, whereupon the deposition of the PVD layer (12) on the adhesion promoting layer (13) is carried out.

15. Method according to one the claims 11 to 14, wherein the process parameters, in particular the temperature, the atmosphere pressure, and the bias voltage, are set such that possibly no hexagonal crystallite but only cubic crystallites are formed in the crystalline phases in the PVD layer (12).

## Revendications

1. Plaquette de coupe amovible (10) comprenant un corps de base (11) avec des surfaces libres et au moins une surface de coupe,
**caractérisée en ce que** la ou les surfaces de coupe du corps de base (11), mais pas ses surfaces libres, sont revêtues par un procédé PVD avec une couche PVD (12) composée d'un matériau dur et dont l'épaisseur de couche est supérieure à 50 µm,
dans laquelle le matériau dur est présent sous forme d'un nanolaminé comprenant une pluralité de couches distinctes (122).

2. Plaquette de coupe amovible (10) selon la revendication 1, dans laquelle l'épaisseur de couche de la couche PVD (12) est supérieure à 100 µm, en particulier supérieure à 150 µm ou supérieure à 200 µm.

3. Plaquette de coupe amovible (10) selon l'une des revendications 1 ou 2,
dans laquelle le matériau dur dans la couche PVD (12) est entièrement ou principalement nanocristallin, et possède en particulier une structure cristalline cubique.

4. Plaquette de coupe amovible (10) selon l'une des revendications 1 à 3,
dans laquelle le matériau dur est un nanocomposite, lequel est formé entièrement ou principalement de nitrites.

5. Plaquette de coupe amovible (10) selon l'une des revendications 1 ou 2, dans laquelle les couches distinctes (122) du nanolaminé sont composées de nitrites différents.

6. Plaquette de coupe amovible (10) selon l'une des revendications 1 à 5, dans laquelle la plaquette de coupe amovible (10) y compris la couche PVD (12) est revêtue en outre avec au moins une couche tribologique.

7. Plaquette de coupe amovible (10) selon la revendication 6, dans laquelle les surfaces libres du corps de base (11) sont également revêtues.

8. Plaquette de coupe amovible (10) selon l'une des revendications 1 à 7, dans laquelle une couche supplémentaire composée de matériau dur est disposée entre le corps de base (11) et la couche PVD (12).

9. Plaquette de coupe amovible (10) selon la revendication 8, dans laquelle la couche supplémentaire est composée d'un matériau tel qu'elle agit comme une couche favorisant l'adhérence (13) entre la couche PVD (12) et le corps de base (11).

10. Plaquette de coupe amovible (10) selon la revendication 9, dans laquelle la couche supplémentaire (13) est composée en partie ou entièrement de CrN.

11. Procédé destiné à fabrique des plaquettes de coupe amovible (10), comprenant les étapes suivantes :
le fait de préparer des corps de base (11) de plaquettes de coupe amovible avec des surfaces libres et au moins une surface de coupe ;
la déposition par un procédé PVD d'une couche épaisse (12) d'au moins 50 µm composée d'un matériau dur sur les surfaces de coupe des corps de base (11), le matériau dur étant présent sous forme d'un nanolaminé comprenant une pluralité de couches distinctes (122).

12. Procédé selon la revendication 11, dans lequel la déposition se poursuit jusqu'à ce que la couche PVD (12) ait une épaisseur supérieure à 100 µm, en particulier supérieure à 150 µm ou supérieure à 200 µm.

13. Procédé selon l'une des revendications 11 ou 12, dans lequel
pendant la déposition de la couche PVD (12) les corps de base (11) sont disposés dans une chambre de procédé PVD avec au moins une source de vaporisation (35, 36) et
les corps de base sont disposés par rapport à la source de vaporisation (35, 36) ou à l'une des sources de vaporisation (35, 36) de telle façon que presque exclusivement les surfaces de coupe des corps de base (11) sont revêtues.

14. Procédé selon l'une des revendications 11 à 13, dans lequel avant la déposition de la couche PVD (12) le corps de base (11) est revêtu au moins en partie avec une couche favorisant l'adhérence (13), en particulier avec une couche composée de CrN, de ZrN, de TiN ou d'un alliage des produits susmentionnés, après quoi la déposition de la couche PVD (12) sur la couche favorisant l'adhérence (13) a lieu.

15. Procédé selon l'une des revendications 11 à 14, dans lequel les paramètres du processus, en particulier la température, la pression atmosphérique et la tension de polarisation, sont réglés de telle façon que dans les phases cristallines de la couche PVD (12) si possible aucune cristallite hexagonale n'est formée mais exclusivement des cristallites cubiques.
